# DEMANDE DE BREVET EUROPEEN

(11) **EP 4 545 895 A1**
(43) Date de publication de la demande: **30.04.2025**
(21) Numéro de dépôt: 24208724.5
(22) Date de dépôt: 24.10.2024
(51) Int. Cl.: F28D 15/04, F28F 21/08

(54) **DIFFUSEUR THERMIQUE DIPHASIQUE CAPILLAIRE COMPRENANT UN TREILLIS FABRICATION ADDITIVE DE CE DIFFUSEUR**

(30) Priorité: 26.10.2023 FR 2311620
(71) Demandeur: THALES, 92190 Meudon (FR); Centre National d'Etudes Spatiales, 75001 Paris (FR)
(72) Inventeur: RAYNAUD, Martin, 06156 CANNES (FR); GARLAND, Estelle, 06156 CANNES (FR); MONTREDON, Florence, 06156 CANNES (FR)
(74) Mandataire: Atout PI Laplace

(57) **Abrégé**

L'invention concerne un d'un diffuseur thermique diphasique (10), ledit diffuseur comprenant une enveloppe (11), un volume interne (20) pour accueillir un fluide caloporteur et une structure interne pour la condensation et le déplacement capillaire dudit fluide. La structure interne comprend un treillis (9) en trois dimensions parcourant tout ou partie du volume interne (20) et s'appuyant sur des portions opposées de l'enveloppe (11), ledit treillis (9) étant composé de mailles (1) hexaédriques centrées.

## Description

### [DOMAINE TECHNIQUE]

L'invention concerne les diffuseurs thermiques linéaires ou surfaciques et leur fabrication. Plus particulièrement, l'invention concerne les diffuseurs thermiques construits autour d'une cavité dans laquelle évolue un fluide caloporteur diphasique, le diffuseur comprenant de plus une structure capillaire dans la cavité. L'invention s'applique à la diffusion de chaleur pour refroidir des dispositifs électroniques, notamment dans le domaine spatial.

### [ARRIÈRE PLAN]

Les diffuseurs thermiques diphasiques sont des dispositifs qui permettent le déplacement de chaleur provenant d'une source localisée aux fins de son étalement et finalement de sa dissipation. Cet étalement est induit par le changement de phase d'un fluide caloporteur initialement liquide contenu dans une enveloppe scellée en contact avec la source localisée de chaleur, et transmettant la chaleur de la source de chaleur au fluide qu'elle contient. Le fluide sous l'effet de la chaleur s'évapore localement tout en restant dans le volume interne (ou cavité) de l'enveloppe scellée et se déplace jusqu'à des zones plus froides car éloignées de la source localisée, où il se condense avant d'être ramené ou de revenir par lui-même à la zone de chaleur. La partie du diffuseur où le fluide s'évapore est la zone d'évaporation ou évaporateur. De la même manière la partie plus froide permettant la condensation est la zone de condensation ou condenseur. Le retour du fluide à l'état liquide au point chaud est une étape importante et peut être assuré par des méthodes actives avec l'emploi de pompe, ou par des méthodes passives avec des systèmes capillaires.

Les boucles diphasiques par exemple, peuvent être passives avec un système capillaire ou actives avec une pompe qui force le déplacement du fluide. D'autres systèmes, dits oscillants, permettent le déplacement de chaleur avec l'existence de bulles de vapeur dans le fluide liquide qui vont augmenter ou diminuer en volume en fonction de la température et ainsi osciller.

Les diffuseurs thermiques diphasiques peuvent être à une dimension (linéaires), ce sont alors des caloducs (heat-pipe en anglais), qui prennent la forme de tuyau souvent de forme en cylindre de révolution. Les caloducs peuvent être implémentés en réseaux de caloducs indépendants les uns aux autres. Les caloducs peuvent comprendre un système capillaire.

Les diffuseurs thermiques diphasiques peuvent aussi être des structures à deux dimensions (surfaciques) comme les chambres à vapeur ou des caloducs oscillants qui sont des structures en général planes.

Les chambres à vapeur (en deux dimensions) comprennent : une enveloppe, un fluide caloporteur et une structure capillaire à l'intérieur de l'enveloppe. La structure capillaire assure le retour du liquide condensé dans la zone d'évaporation et elle peut être une toile métallique rapportée aussi appelée mèche, des rainures ou de la poudre métallique frittée.

Les chambres à vapeur peuvent comprendre aussi un ensemble de colonnes ou piliers assurant un soutien mécanique. De tels éléments de liaison mécanique sont nécessaires pour empêcher l'effondrement de la chambre sur elle-même ou son éclatement lors des variations, parfois très importantes, de pression. Les matériaux de fabrication de l'enveloppe ainsi que le fluide caloporteur sont choisis en fonction de contraintes mécaniques et des températures minimales et maximales d'utilisation du dispositif et donc de son application. Le couple cuivre - eau est, par exemple, employé pour la diffusion de chaleur des circuits électroniques courants, tandis que pour des applications spatiales l'aluminium et l'ammoniac sont privilégiés.

Lors de la fabrication de la chambre à vapeur, différents éléments la constituant sont fabriqués séparément et assemblés avant de remplir la chambre avec le fluide caloporteur. La chambre à vapeur est ensuite mise en place sur la source de chaleur et maintenue en place par des supports de fixation soit directement présents dans la structure de la chambre soit par des éléments de fixations rapportés. Ces étapes de fabrication sont coûteuses et complexes. Par exemple l'introduction d'une toile métallique nécessite la fabrication a priori de la mèche avant l'insertion, tandis qu'un système de rainures nécessite une matrice d'extrusion à la géométrie complexe ou un usinage. En fonction du système capillaire, des étapes supplémentaires sont à prendre en considération lors de la fabrication. Par ailleurs, les différentes parties assemblées ainsi que les éléments de fixation sont soumis à de fortes contraintes mécaniques et thermiques.

Une solution proposée récemment par OZGUC et al. 'Experimental Démonstration of an Additively Manufactured Vapor Chamber Heat Spreader'. In : 18th IEEE Intersociety Conférence on Thermal and Thermomechanical Phenomena in Electronic Systems (ITherm). Las Vegas, USA, 2019, p. 416-422 consiste à réaliser la chambre à vapeur par synthèse additive, et plus particulièrement par fusion laser sur lit de poudre. Ce procédé de fabrication consiste à fusionner la poudre composée du matériau souhaité pour la fabrication, ici de l'acier inoxydable. Le laser forme couche après couche la structure souhaitée et la variation des paramètres d'impression, tels que la puissance du laser ou son pas, permet la création de motifs ou de structures poreuses.

La chambre à vapeur ainsi fabriquée comprend une enveloppe, une structure capillaire poreuse et une série de colonnes servant de liaison mécanique pour maintenir l'enveloppe lors des variations de pression et ainsi prévenir son éclatement ou son effondrement. Les colonnes sont poreuses et offrent une zone de capillarité supplémentaire.

Afin d'éviter la présence de structures horizontales suspendues tels que des ponts, les colonnes sont inclinées à 45° selon la verticale.

La fabrication de diffuseurs thermiques diphasiques capillaires implique des contraintes liées à la géométrie du diffuseur (une ou deux dimensions) et le système capillaire employé qu'il soit rainuré, une toile métallique ou de la poudre frittée métallique. L'utilisation de la synthèse additive qui vise à s'affranchir de ces problématiques, ajoute de nouveaux inconvénients cités précédemment notamment l'impératif du dépoudrage.

Lors de la fabrication d'un élément par fusion sur lit de poudre, il est en effet nécessaire d'éliminer la poudre excédentaire par une opération dite de dépoudrage. Cette opération peut s'effectuer en projetant de l'air sous pression sur les éléments recouverts de poudre. Mais dans le cadre d'une fabrication d'un diffuseur thermique tel qu'une chambre à vapeur, le dépoudrage est une étape ayant lieu dans une cavité avec un système capillaire pouvant être, par exemple, du métal fritté. Il est donc contraignant.

Par ailleurs, à ces contraintes de fabrication sont associées le besoin d'obtenir un système assurant suffisamment de capillarité pour diffuser la chaleur.

Une solution est proposée par MENG et al., 'Experimental study on the heat transfert performance of a vapour chamber with porous wick structures printed via metallic additive manufacturing'. In: International Communications in Heat and Mass Transfer, Vol 40, 2023. La structure interne de la chambre à vapeur est réalisée par fusion laser sur lit de poudre de cuivre.

Cette structure comprend deux treillis le long des parois principales de la chambre, séparés par un ensemble de colonnes. Les treillis sont composés de mailles différentes.

Le premier treillis comprend des mailles cubiques qui privilégient l'évaporation et le déplacement de la vapeur. Ces mailles cubiques permettent d'après les auteurs à la vapeur de se déplacer avec facilité.

L'autre treillis comprend des mailles à base de surfaces gyroïdes pour la condensation du fluide. Les surfaces gyroïdes permettent d'après les auteurs d'obtenir une grande surface pour que la vapeur se condense en liquide à son contact.

Les colonnes qui se situent entre les deux treillis et permettent de soutenir l'ensemble sont composées de surfaces de Schwarz, choisies d'après les auteurs pour permettre un déplacement capillaire. Ces surfaces présentes sous la forme de colonne permettent au fluide condensé sous forme liquide de revenir à la zone de chaleur. Ces colonnes sont disposées d'après les auteurs afin d'assurer un support mécanique et un retour capillaire tout en conservant suffisamment d'espace libre pour le déplacement de la vapeur.

La chambre à vapeur ainsi créée comporte donc une orientation impérative d'utilisation afin que les zones correspondant à l'évaporation ou la condensation soient correctement orientées selon la source de chaleur.

### [RÉSUMÉ DE L'INVENTION]

Afin de pallier tout ou partie des inconvénients précités, l'invention consiste en un diffuseur thermique diphasique, ledit diffuseur comprenant une enveloppe, un volume interne pour accueillir un fluide caloporteur et une structure interne pour l'évaporation, le déplacement capillaire et la condensation dudit fluide, ladite structure interne comprend un treillis tridimensionnel parcourant tout ou partie du volume interne et s'appuyant sur des portions opposées de l'enveloppe, ledit treillis étant composé de mailles parallélépipédiques, voire de manière générale hexaédriques, centrées.

Il s'agit là de caractéristiques qui permettent et facilitent l'évaporation, le déplacement du fluide caloporteur et la condensation.

Le treillis est composé de mailles qui peuvent être répétées dans une ou plusieurs directions d'élongation de l'enveloppe. Les mailles assurent une importante surface de contact entre la vapeur et une matière solide à proximité de tout point du volume interne du diffuseur. L'effet de capillarité est assuré par les mailles de par leur forme et leur état de surface, au vu du fluide concerné, qui se condense au contact du treillis et se déplace ensuite le long des mailles. En outre, Le treillis parcourant le volume interne, le retour au point de contact chaud est facilité pour le fluide condensé.

L'effet capillaire est alors assuré par le treillis qui permet de déplacer le fluide sous forme liquide du condenseur à l'évaporateur. Par ailleurs, les barres de treillis, parce qu'elles s'appuient sur des portions opposées de l'enveloppe, offrent un support mécanique entre les faces de l'enveloppe du diffuseur thermique, et plus particulièrement lorsque ledit diffuseur est en deux dimensions comme une chambre à vapeur, et que les portions opposées de l'enveloppe sont des parties des grandes faces de la chambre. Ce support mécanique assure, en fonctionnement, une résistance en compression et en cisaillement. Elle est utile notamment quand l'enveloppe n'est pas un cylindre de révolution. Dans ce cas, l'enveloppe dispose, en coupe, d'une petite dimension (l'épaisseur dans le cas d'une chambre à vapeur plane), selon laquelle la mise en place du treillis apporte un effet de résistance mécanique.

En outre, la maille parallélépipédique, voire de manière générale hexaédrique, centrée est très efficace à la fois pour l'évaporation du fluide caloporteur et pour la condensation dudit fluide et pour le déplacement du liquide. La structure ajourée permet à la vapeur de se déplacer efficacement entre les barres des mailles. Les barres elles-mêmes constituent une surface permettant la condensation. En outre, la rugosité des barres et les sillons qui les constituent assurent un retour efficace par capillarité du fluide à la zone de chaleur.

De plus, la maille parallélépipédique, voire de manière générale hexaédrique, centrée, puisqu'elle comprend des barres selon les diagonales du parallélépipède ou de l'hexaèdre offre un soutien mécanique amélioré à l'enveloppe. Ce soutien mécanique comprend toutes les directions et permet de résister à l'éclatement ou à l'effondrement.

Le treillis à mailles hexaédriques centrées, et dans certains modes de réalisation, parallélépipédiques centrées, est par définition à base de barres et forme donc une structure ajourée parcourant le volume interne du diffuseur thermique et laissant circuler la vapeur depuis la zone de chaleur de contact entre l'élément chauffant et l'enveloppe du diffuseur vers des zones plus froides de la cavité (le volume interne de l'enveloppe, qui est parcouru par le treillis). Les barres elles-mêmes permettent le retour du liquide dans la zone de chaleur par effet capillaire. Le treillis est donc un treillis capillaire.

Dans un mode de réalisation, les mailles constituant le treillis capillaire sont cubiques centrées.

L'invention, et plus particulièrement le treillis interne à maille cubique centrée, permet de simplifier la prise en compte des contraintes de direction de fabrication associée à la synthèse additive. Plus particulièrement, les angles entre les barres formant la maille cubique centrée permettent la fabrication de la maille dans toutes les directions possibles sans créer d'éléments suspendus. Les mailles du treillis permettant de soutenir la paroi fermante lors de la fabrication couche par couche.

Dans un mode de réalisation, les barres formant les mailles du treillis ont un profil en étoile.

Les sillons anguleux présents entre chaque branche de l'étoile augmentent l'effet capillaire de ladite barre lors du déplacement du liquide. Ils agissent alors comme des rainures le long des barres.

Dans un mode de réalisation, les jonctions des barres au centre d'une maille ou au noeud commun de deux mailles voisines sont percées de manière traversante.

Les ouvertures aux jonctions des barres offrent un passage supplémentaire au liquide. Ainsi, le liquide rejoint plus rapidement les zones chaudes du diffuseur thermique et améliore la capacité du diffuseur à déplacer la chaleur.

Dans un mode de réalisation, le treillis comprend un nombre entier supérieur ou égal à deux de demi-mailles.

Dans un mode de réalisation, la méthode de fabrication additive employée est la fusion laser sur lit de poudre.

De manière originale, la fabrication de l'enveloppe et de la structure interne comprend la construction du treillis en trois dimensions parcourant une partie du volume interne, voire tout le volume interne, et prenant naissance sur des portions opposées de l'enveloppe et dont la maille assure un effet de capillarité pour le fluide condensé. On obtient ainsi un diffuseur thermique monobloc 3D comprenant un treillis capillaire volumineux qui parcourt le volume interne à l'enveloppe du diffuseur.

Le treillis au sein du volume interne de par sa structure ajourée facilite l'opération de dépoudrage qui est nécessaire avant l'introduction du fluide caloporteur.

Lors de la fabrication du diffuseur thermique, les mailles du treillis prennent naissance sur les faces internes de l'enveloppe du diffuseur. De cette façon, la jonction entre le treillis et l'enveloppe est continue et ne présente pas de séparation. Cette continuité renforce la résistance aux contraintes mécaniques et plus particulièrement de pression à très basse ou très haute température. Ainsi, les mailles du treillis sont continues avec la partie interne de l'enveloppe du diffuseur et offrent une liaison mécanique entre les faces de l'enveloppe. Elles permettent d'éviter l'effondrement et l'éclatement de l'enveloppe en cas de forte variation de pression entre l'extérieur et l'intérieur de la chambre.

Ainsi, le procédé de fabrication est particulièrement avantageux.

De plus, l'invention permet l'intégration du diffuseur thermique dans des structures mécaniques telles que des treillis mécaniques. Ce type de structure se retrouve notamment dans des panneaux rayonnants de satellites. L'invention est directement intégrée dans la structure lors du processus de fabrication de cette dernière. Avantageusement, les contraintes mécaniques et thermiques à l'interface du diffuseur thermique et de la structure mécanique sont réduites. Dans l'exemple d'intégration du diffuseur à un panneau de satellite, la fabrication en un unique bloc du panneau et du diffuseur améliore la capacité de rejection thermique du panneau.

En outre, la fabrication additive permet d'obtenir des barres rugueuses qui constituent les mailles du treillis, la rugosité améliore ainsi la capillarité du diffuseur thermique.

Dans un mode de réalisation, la fabrication par synthèse additive du diffuseur thermique de l'enveloppe et du treillis interne est réalisée en aluminium ou en alliage d'aluminium.

Le diffuseur thermique ainsi réalisé est alors léger et peut être utilisé pour des applications spatiales pour lesquelles les contraintes de poids sont importantes.

Dans un mode de réalisation, le diffuseur thermique réalisé est une chambre à vapeur dont l'enveloppe comprend deux surfaces opposées, par exemple planes, et dont le treillis prenant naissance sur une surface interne d'une face de la chambre à vapeur configurée pour la mise en contact avec un élément à refroidir.

La chambre à vapeur réalisée selon le procédé de fabrication évoqué précédemment peut se placer contre un élément chauffant comprenant une ou plusieurs sources de chaleur. L'élément chauffant est alors en contact avec l'enveloppe de la chambre. Plus particulièrement, l'élément dont on souhaite étaler et dissiper la chaleur est en contact avec une des deux grandes surfaces opposées et planes de l'enveloppe de la chambre à vapeur.

Le treillis parcourant la chambre à vapeur et dont les mailles prennent naissance sur les parois internes de la chambre permet au fluide caloporteur de circuler sous forme liquide dans toute la chambre. Le treillis permet ainsi de diffuser avantageusement la chaleur provenant de plusieurs sources localisées et d'assurer une liaison mécanique dans la chambre à vapeur.

La chambre à vapeur remplace alors avantageusement un réseau de caloducs dont le placement requiert une étude préalable de l'élément chauffant et de ses points chauds. En outre, le treillis qui occupe tout ou une partie du volume interne et parce qu'il est composé d'une maille répétée dans une ou plusieurs directions d'élongation de la chambre permet l'utilisation de la chambre à vapeur sur une face ou l'autre sans distinction.

Dans un mode de réalisation, le diffuseur thermique est un caloduc de la forme d'un cylindre de révolution et dont le treillis parcourt le volume interne et prend naissance sur des portions opposées de l'enveloppe.

La forme de cylindre de révolution du caloduc permet de supporter les fortes variations de pression et éviter l'éclatement ou l'effondrement de l'enveloppe. Le treillis parcourant le volume interne, parce qu'il prend naissance sur des portions opposées de l'enveloppe, renforce cette résistance aux variations de pression. Ainsi, l'enveloppe du caloduc peut être affinée sans compromettre la résistance du diffuseur thermique et la masse du caloduc peut ainsi être diminuée. La réduction de la masse du dispositif est alors un avantage lors de l'utilisation du caloduc dans un contexte spatial.

Selon un autre aspect de l'invention, celle-ci concerne, un diffuseur thermique diphasique comprenant une enveloppe, un volume interne pour accueillir un fluide caloporteur et une structure interne sous la forme d'un treillis pour la condensation et le déplacement capillaire dudit fluide, le diffuseur thermique étant obtenu par fabrication additive selon les principes évoqués plus haut.

Dans un mode de réalisation, la chambre à vapeur ainsi réalisée comprend des zones de matière pleine pour l'ajout de fixations traversant l'enveloppe et le volume interne de la chambre à vapeur ou non.

Ces zones de fixations sont des éléments pleins pouvant être percés ou rivetés. Ils permettent de fixer le diffuseur thermique à la source de chaleur. De telles zones, lorsqu'elles sont directement intégrées dans la fabrication du diffuseur et traversantes, réduisent les contraintes mécaniques et thermiques sur le système auquel est intégré le diffuseur thermique.

### [BRÈVE DESCRIPTION DES DESSINS]

L'invention sera mieux comprise et d'autres avantages, détails et caractéristiques apparaitront à la lecture de la description explicative qui suit, faite à titre d'exemple et grâce aux figures parmi lesquelles :
- la figure 1 représente une maille cubique centrée pouvant être utilisée pour composer un treillis ;
- la figure 2 est une section et illustre la forme en étoile des barres d'un treillis capillaire selon un mode de réalisation de l'invention ;
- la figure 3 illustre une maille du treillis capillaire selon le même mode de réalisation ;
- la figure 4 illustre une vue d'un alignement de mailles formant un treillis à une couche unique ;
- la figure 5 illustre une vue en coupe d'un mode de réalisation de l'invention constituant une chambre à vapeur comprenant un treillis ;
- la figure 6 illustre deux vues en coupe de deux modes de réalisation de l'invention constituant chacun une chambre à vapeur comprenant un treillis tridimensionnel ;
- la figure 7 représente en vue de trois-quarts une chambre à vapeur selon l'invention;
- la figure 8 illustre, en vue de trois-quarts, un ensemble monobloc d'une structure mécanique et d'une chambre à vapeur selon l'invention intégrée dans la structure mécanique.

### [DESCRIPTION DÉTAILLÉE]

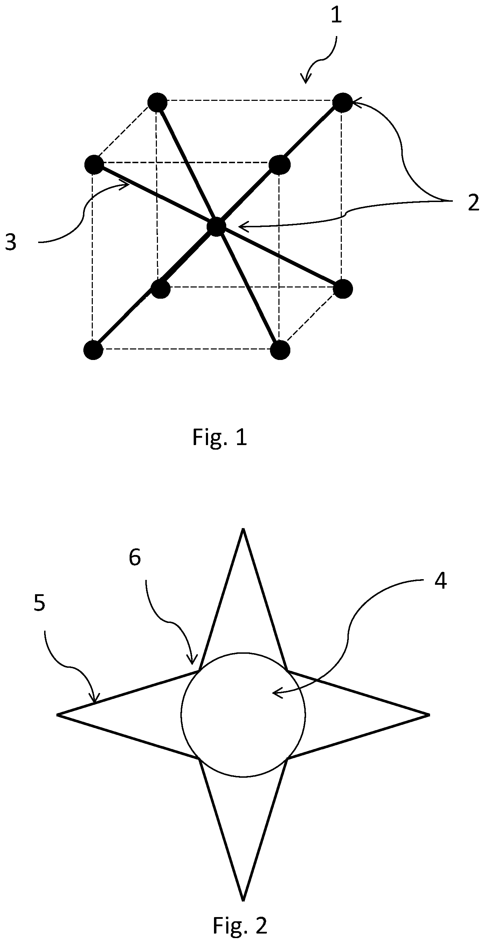

[Fig. 1] La figure 1 représente schématiquement une maille 1 cubique centrée pouvant composer un treillis utilisé dans l'invention. Les cercles noirs illustrent les noeuds 2 et sont agencés en réseau cubique centré. Les lignes noires continues représentent les barres 3 de la maille et se rejoignent en des noeuds. Les pointillés représentent les limites d'une maille 1, deux mailles 1 peuvent être adjacentes. Cette maille 1 répétée dans une, deux ou trois directions forme le treillis tridimensionnel.

Pour les caloducs, il est prévu d'utiliser un tel treillis dont la maille se répète dans une unique direction, à savoir celle de la lumière du caloduc. Pour les chambres à vapeur, il est prévu d'utiliser un tel treillis dont la maille se répète ou les mailles se répètent dans deux directions, à savoir celles de la cavité interne de la chambre à vapeur.

[Fig. 2] La figure 2 est une section d'une barre 3 utilisable pour un treillis dont les mailles comprennent des barres, par exemple la maille 1 cubique centrée selon la figure 1. La barre comprend une âme 4 qui est essentiellement un cylindre de révolution de diamètre par exemple 0,6 mm et des branches 5 (ici au nombre de quatre, mais un nombre différent peut être envisagé), chacune de même géométrie réparties régulièrement autour de l'âme 4 et s'affinant progressivement à distance de celle-ci, jusqu'à une extrémité qui peut être en pointe, environ 1,3 mm au-dessus de l'axe du cylindre de révolution formant l'âme 4 de la barre 3. À sa base, chacune des branches côtoie la branche 3 voisine, leur jonction constituant un sillon 6 dont le fond est anguleux. Ce sillon 6 favorise la capillarité au niveau des barres 3 permettant à un fluide liquide de se déplacer. La présence de quatre sillons est avantageuse puisqu'on offre ainsi 4 trajets favorables pour le fluide.

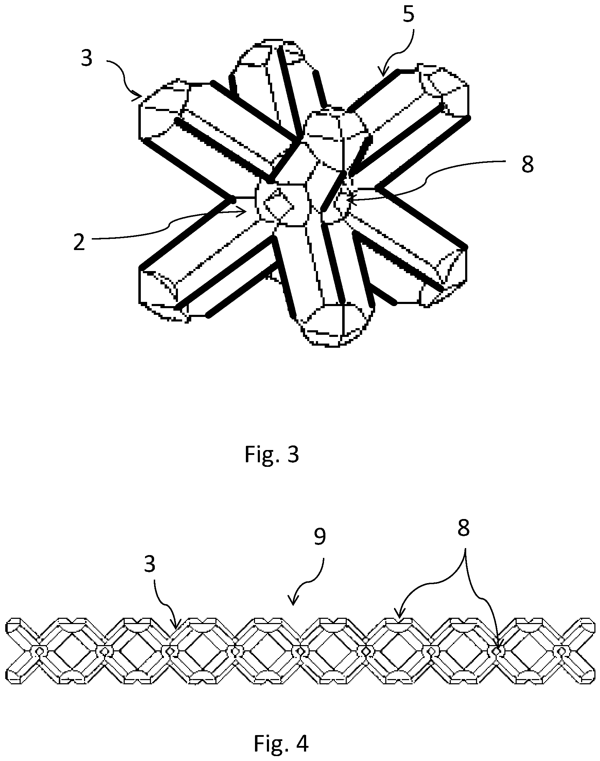

[Fig. 3] La figure 3 illustre une réalisation d'une maille 1 cubique centrée formée de barres 3 en forme d'étoile à quatre branches 5 conformes à la figure 2. La maille 1 représentée comprend quatre barres 3, qui sont chacune sécante en son milieu avec les autres, au centre du cube : il s'agit des diagonales du cube. Les barres 3 ont chacune quatre arêtes saillantes correspondant aux pointes de l'étoile présentée en figure 2 qui sont explicitées en figure 3 par des lignes plus épaisses. Les sillons 6 que forment les angles rentrants entre les branches correspondent, en figure 3, aux lignes plus fines sur la longueur des barres.

L'intersection au centre de la maille 1 des quatre barres 3 forme un noeud 2 dans lequel ont été ménagées trois ouvertures 8 traversantes. Dans le mode de réalisation représenté, le noeud 2 comporte trois passages de diamètre 0,4 mm traversants à 90° l'un de l'autre, parallèles à des arêtes du cube. Le diamètre de l'ouverture 8 est un paramètre variable entre 0 mm, caractérisant une absence d'ouverture, et jusqu'à une valeur inférieure au diamètre de l'âme de la barre 3 comme définie dans la figure 2.

Les ouvertures 8 traversantes au centre des noeuds 2 offrent un passage supplémentaire au liquide afin qu'il rejoigne la zone d'évaporation plus rapidement. De plus, le fluide sous forme liquide se déplace le long des barres 3 et des sillons 6 qui les composent.

[Fig. 4] La figure 4 illustre une vue d'un alignement de mailles 1 cubiques centrées selon une direction, ici horizontale, formant un treillis 9 à une couche unique de mailles 1 cubiques centrées. Les noeuds 2 où les barres 3 se rejoignent, au bord d'une maille 1 ou au centre de celle-ci, comportent trois ouvertures 8 traversantes comme évoqué ci-dessus. Les trois ouvertures 8 au centre des noeuds sont perpendiculaires les unes par rapport aux autres. Dans le mode de réalisation présenté, les mailles 1 du treillis 8 sont adjacentes et les cubes formant la maille 1 ont un côté de 2,85 mm. Cette valeur définit le pas du treillis 9 et peut varier notamment entre 1 mm et 5 mm, voire entre 0,5 mm et 8 mm.

La réunion de quatre barres 3 de mailles voisines forme, en vue de côté, un carré. Deux des sommets opposés de ce carré constituent la jonction des barres 3 des deux mailles 1 adjacentes sur les faces extérieures des couches. Les deux autres sommets se situent au niveau des noeuds 2 centraux des deux mailles 1 adjacentes.

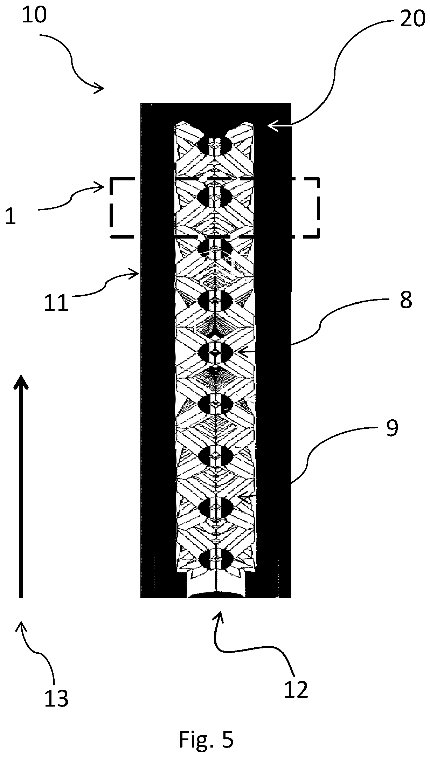

[Fig. 5] La figure 5 illustre une vue en coupe d'un mode de réalisation de l'invention constituant un diffuseur thermique diphasique 10 comprenant un treillis 9 tel qu'évoqué précédemment. Le diffuseur thermique 10 est formé d'une enveloppe 11 de la forme d'un pavé droit avec deux dimensions d'extension (une des deux dimensions n'est pas visible sur la figure) et entourant un volume interne 20 occupé intégralement par une couche, ici unique, de treillis 9 s'étendant dans les deux dimensions d'extension du diffuseur thermique 10. Le diffuseur thermique 10 peut par exemple être une chambre à vapeur.

Dans le mode de réalisation représenté, les mailles 1 du treillis 9 sont cubiques centrées et adjacentes les unes avec les autres. Les mailles 1 composant le treillis 9 sont alignées selon les deux directions mentionnées et l'épaisseur de maille 1 est égale à la hauteur du volume interne de la chambre. Le treillis 9 est composé d'un seul étage de mailles 1. L'espace entre les barres 3 des mailles 1 offre un passage à la vapeur alors que le treillis 9 occupe néanmoins tout le volume interne de la chambre à vapeur.

Dans le mode de réalisation représenté, le treillis 9 parcourt l'intégralité du volume interne 20 du diffuseur thermique 10. Des modes de réalisation alternatifs comprendront un treillis 9 parcourant une partie seulement du volume interne 20, ou parcourant de façon discontinue le volume interne 20 du diffuseur thermique 10.

Les barres 3 elles-mêmes permettent au liquide de se déplacer par capillarité. De plus, le treillis 9 prenant naissance sur les parois internes de l'enveloppe 11 offre une liaison mécanique au diffuseur thermique 10 permettant de prévenir les éclatements ou effondrements lors de fortes variations de température. Les mailles 1 présentent de plus trois ouvertures 8 traversantes en leurs jonctions et noeuds 2 centraux, augmentant la capillarité.

L'enveloppe 11 du diffuseur 10 a deux grandes surfaces internes pleines et planes qui se font face autour du treillis, ainsi que quatre flancs latéraux internes entourant aussi le treillis, et joignant les deux grandes surfaces. Les barres prennent naissance sur ces deux grandes surfaces internes et sur ces quatre flancs latéraux internes.

L'épaisseur des parois composant l'enveloppe 11 peut par exemple prendre la valeur de 1,5 mm et varier autour de cette valeur. Le diffuseur thermique 10 supporte, sans altération de l'enveloppe 11, des pressions jusqu'à plus de 100 bars lors de son utilisation.

Un tube de remplissage 12 pour le fluide caloporteur est aussi présent sous la forme d'un cylindre de révolution creux. Cette ouverture sera par la suite scellée pour permettre le fonctionnement du diffuseur thermique 10.

La flèche noire 13 indique la direction de fabrication du diffuseur thermique 10 par synthèse additive et plus précisément par fusion laser sur lit de poudre d'alliage d'aluminium, ici en commençant par la face comprenant le tube de remplissage 12. La direction de fabrication, qui est menée verticalement, suit une des directions d'élongation du diffuseur thermique 10. Le matériau utilisé est l'aluminium, allié ou non allié, et en tout état de cause, est choisi pour d'une part conduire la chaleur et d'autre part, être compatible chimiquement, y compris sur le long terme, avec le fluide introduit dans la cavité.

Le fluide introduit par le tube de remplissage 12 est dans le mode de réalisation décrit, de l'ammoniac, introduit sous forme liquide (c'est-à-dire à basse température et/ou haute pression). Un autre fluide peut être utilisé.

Du fait des impératifs de la fabrication additive, les dernières mailles 1 fabriquées présentent un surplus de matière depuis le centre de la maille 1 jusqu'au bout des barres 3 les constituant vers le haut en suivant la direction de fabrication. Ce surplus est de la forme d'une pyramide dont la base est contre la paroi (un des flancs) du diffuseur thermique 10 et le sommet est constitué du noeud 2 central de la maille 1. Ce surplus est de la même densité que l'enveloppe 11 et est constituée de manière intégrale avec la dernière surface fabriquée de l'enveloppe 11, ici la surface supérieure qui constitue la paroi de fermeture. Dans un mode de réalisation particulier, ce surplus peut être remplacé par un treillis (9) dont le pas de maille est plus fin jusqu'à la paroi fermante de l'enveloppe.

Les barres 3 constituant les mailles 1 du treillis, ici cubiques centrées, ont une surface rugueuse. Cette rugosité provient de la fabrication additive et augmente la capillarité des barres 3 du treillis 9.

Lors de l'utilisation du diffuseur thermique 10, un élément chauffant est en contact avec une zone limitée d'une des grandes faces externes de l'enveloppe 11. En chauffant, le fluide caloporteur contenu dans la chambre à vapeur passe à l'état gazeux. Sous forme de vapeur, le fluide se déplace au travers du treillis 9 en s'éloignant de la zone de contact avec l'élément chauffant, entre les barres 3 des mailles 1. La vapeur se déplace ainsi jusqu'à des zones plus froides de la chambre à vapeur, considérées comme un condenseur. Au contact de surfaces plus froides, comme des parties froides des faces internes de l'enveloppe 11 ou des barres 3, la vapeur se condense. Le fluide caloporteur sous forme liquide, par effet de capillarité, se déplace alors le long des barres 3, dans les ouvertures 8 présentes aux jonctions des mailles 1 et dans les sillons 6 jusqu'à rejoindre de nouveau la zone chauffée du diffuseur thermique 10.

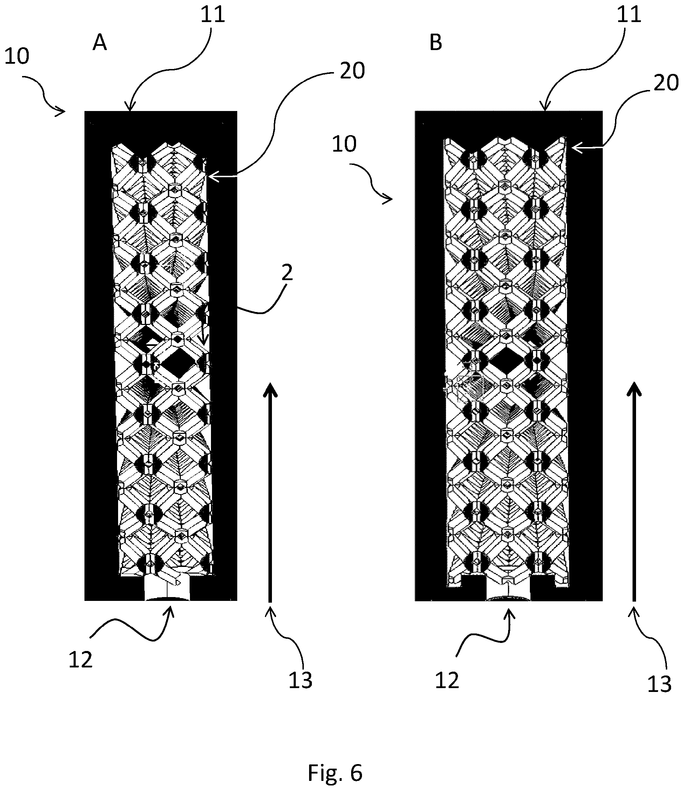

[Fig. 6] La figure 6 illustre des vues en coupe de deux modes de réalisation de l'invention constituant chacun un diffuseur thermique 10 comprenant un treillis 9 tridimensionnel qui parcourt un volume interne 20. Dans ces deux modes de réalisation, la maille 1 composant le treillis 9 est cubique centrée et formée de barres 3 en étoiles tel qu'évoqué en relation aux figures 3 et 4. L'épaisseur de mailles du treillis 9 parcourant le volume interne 20 varie passant d'un étage composé d'une unique maille 1 (en figure 5) à une maille et demie pour le mode de réalisation de la partie A de la figure 6 et deux mailles 1 pour le mode de réalisation de la partie B de la figure 6. L'épaisseur de mailles 1 du treillis 9 peut en effet s'exprimer en demi-mailles, du fait de la structure cubique centrée.

Le mode de réalisation de la partie A de la figure 6, dont l'épaisseur du treillis 9 est de 1,5 maille, comprend une maille 1 complète prenant naissance sur la paroi interne ainsi qu'une demi-maille 1 qui se termine par le noeud 2 central contre la paroi interne du diffuseur 10.

Le mode de réalisation de la partie B de la figure 6 comprend deux mailles 1 cubiques d'épaisseur. Les mailles 1 prennent naissance et se terminent sur la paroi interne du diffuseur par les barres 3 constituant lesdites mailles.

Pour les deux modes de réalisation avec une maille 1 et demie et deux mailles 1, le tube 12 du diffuseur 10 est centrée à la fois selon le treillis 9 et selon la face sur laquelle il se trouve.

Sur les parties A et B de la figures 6, la flèche noire 13 indique la direction de fabrication des diffuseurs thermiques 10, et un surplus de matière est présent entre les dernières mailles supérieures et la paroi fermante pour les deux modes de réalisation.

Dans ces différents modes de réalisation, la géométrie et la rugosité du treillis conduisent à une grande capillarité.

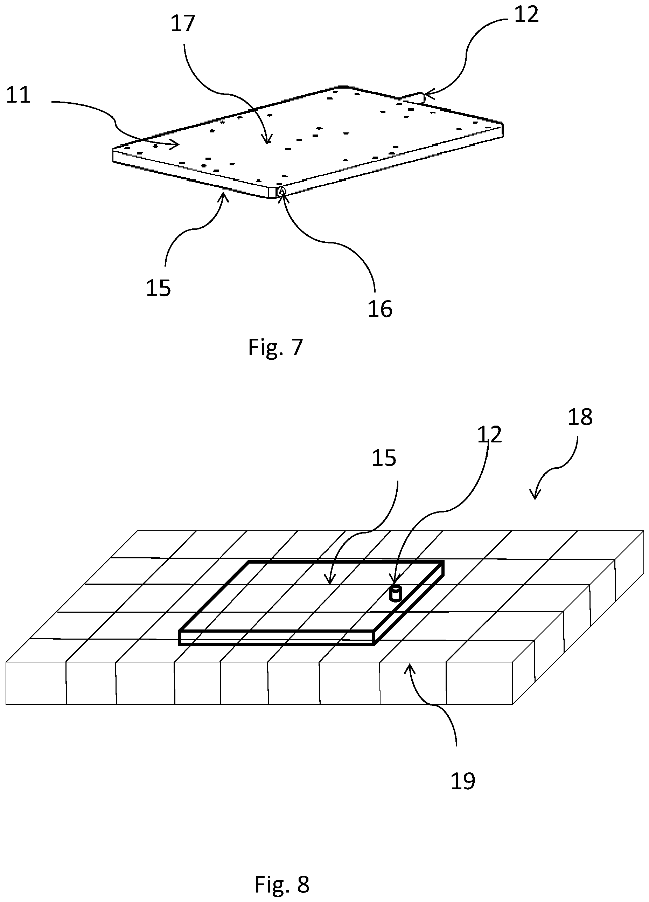

[Fig. 7] La figure 7 représente une chambre à vapeur 15 selon l'invention. La chambre à vapeur 15 est de la forme d'un pavé droit plat et plan dont les faces constituent l'enveloppe 11. L'intérieur de l'enveloppe 11 qui comprend le volume interne de la chambre peut accueillir un treillis 9 d'une ou plusieurs épaisses de mailles 1. Les faces supérieures et inférieures ont les dimensions les plus grandes, constituant deux plans se faisant face.

La chambre à vapeur comprend au moins deux orifices 16 utilisés pour le dépoudrage, qui dans ce mode de réalisation prennent la forme d'un cylindre de révolution creux. Sur deux flancs latéraux et orthogonaux l'un à l'autre sont présentes des ouvertures, à savoir le tube de remplissage 12 et un orifice de dépoudrage 16. Un second orifice de dépoudrage 16 est présent sur un flanc non visible de la figure. Ces orifices de dépoudrage sont utilisés pour retirer la poudre excédentaire issue de la fabrication additive par fusion laser sur lit de poudre.

Les ouvertures se situent sur des flancs allongés latéraux et leur diamètre extérieur est inférieur ou égal à la plus petite dimension du flanc qu'elle traverse.

Dans un mode de réalisation de l'invention, la chambre à vapeur 15 comporte des zones pleines de matière pour la fixation 17 qui sont des cylindres pleins de matière dense traversant la chambre, affleurant sur la surface plane supérieure. Il est possible de percer chacun de ces volumes pour visser ou riveter un élément externe à la chambre dans la matière de celle-ci, ou encore de faire passer un lien au travers de cette matière dense, sans créer de discontinuité au volume interne fonctionnel de la chambre à vapeur. Ces zones pleines de matière pour la fixation 17 sont ensuite utilisées pour fixer la chambre à vapeur 15 à un élément chauffant.

La répartition des cylindres pleins 17 sur la surface est un exemple de disposition possible, d'autres répartitions sont envisageables selon les contraintes liées à l'utilisation de la chambre.

[Fig. 8] La figure 8 illustre, en vue de trois-quarts, un ensemble monobloc 18 d'une structure mécanique 19 et d'une chambre à vapeur 15 selon l'invention intégrée dans la structure mécanique 19. La structure mécanique 19 est représentée sous la forme d'un pavage cubique régulier d'une épaisseur unique.

La structure mécanique 19 peut être soit un treillis mécanique soit de la forme d'alvéoles, on parle alors de structure Nida (en nid d'abeilles). Une telle structure peut être fabriquée par synthèse additive et plus particulièrement, selon l'invention divulguée par le document EP 3 208 200, la structure ainsi fabriquée peut constituer des éléments de panneau pour satellite. La structure présentée de l'invention précédemment citée est fabriquée par synthèse additive et est formée d'un treillis mécanique dont les âmes sont constituées de mailles, par exemple cubiques centrées ou d'autres mailles fabricables sans support par fabrication additive. L'intégration du diffuseur, ici une chambre à vapeur 15, se fait directement lors du processus de fabrication de la structure qu'elle intègre. Cette intégration réduit les contraintes mécaniques et thermiques aux interfaces de la structure et du diffuseur et plus particulièrement sur des éléments externes de fixation.

Une chambre à vapeur 15 selon l'invention est intégrée au centre de la structure mécanique 19. Dans ce mode de réalisation, la chambre à vapeur 15 est un pavé droit plat et plan comportant le tube de remplissage 12 sur l'une de ses faces. Le tube de remplissage 12 se situe sur la face supérieure de la chambre à vapeur 15. Le tube de remplissage 12 doit être accessible pour introduire le fluide caloporteur, ainsi le tube de remplissage 12 peut au besoin être sur l'une des faces ou un des flancs de la chambre à vapeur 15.

Les faces latérales de la chambre sont comprises dans la structure mécanique 19. L'épaisseur de la chambre à vapeur 15, est plus petite que celle de la structure mécanique 19 qu'elle intègre. Dans un mode de réalisation alternatif, l'épaisseur de la chambre à vapeur 15 peut varier de sorte à être supérieure ou égale à l'épaisseur de la structure mécanique 19.

La chambre à vapeur 15 est orientée parallèlement à la structure mécanique 19 selon ses deux directions d'élongation. La chambre peut cependant être placée de manière perpendiculaire par rapport à la structure mécanique 19, de façon à ce qu'elle dépasse dans une des directions. Dans un mode de réalisation alternatif, la chambre à vapeur 15 est située sur la structure mécanique 19.

Dans un mode de réalisation de l'invention, le diffuseur thermique peut être linéaire et sous la forme d'un cylindre de révolution contenant le treillis tridimensionnel. Le diffuseur ainsi fabriqué est alors un caloduc dont le volume interne est parcouru par le treillis et dont les mailles dudit treillis prennent naissance à l'intérieur du cylindre de révolution sur les parois internes du cylindre. Le treillis peut être composé de un ou plusieurs étages de mailles constituant l'épaisseur du treillis. Le treillis assure alors le rôle de la structure capillaire permettant le retour du fluide caloporteur liquide au point de contact avec la source de chaleur.

D'autres variantes de l'invention peuvent être déduites par la personne du métier. Par exemple, l'invention peut être mise en oeuvre dans des boucles diphasiques capillaires, le treillis remplaçant alors le système capillaire tel que la toile ou le métal fritté. Par ailleurs, l'invention peut être mise en oeuvre dans des chambres à vapeurs coudées ou courbées pour s'adapter à la zone de contact avec l'élément chauffant.

Par ailleurs, le treillis peut être constitué de mailles alternatives qui permettent l'évaporation ainsi que la condensation du fluide caloporteur.

La technique de fabrication par fusion laser sur lit de poudre est un exemple avantageux de technique de fabrication additive envisageable. D'autres techniques rentrent néanmoins dans le cadre de l'invention.

## Revendications

1. Diffuseur thermique diphasique capillaire (10), ledit diffuseur (10) comprenant une enveloppe (11), un volume interne (20) pour accueillir un fluide caloporteur et une structure interne pour l'évaporation et le déplacement de gaz, et la condensation et le déplacement de liquide, ledit diffuseur thermique diphasique (10) étant **caractérisé en ce que** la structure interne comprend un treillis tridimensionnel (9) parcourant tout ou partie du volume interne (20) et s'appuyant sur des portions opposées de l'enveloppe, ledit treillis (9) étant composé de mailles (1) hexaédriques centrées.

2. Diffuseur thermique diphasique capillaire (10) selon la revendication 1, **caractérisé en ce que** des jonctions (2) du treillis (9) sont percées de manière traversante.

3. Diffuseur thermique diphasique capillaire (10) selon les revendications 1 ou 2, **caractérisé en ce que** la maille (1) du treillis (9) est cubique centrée.

4. Diffuseur thermique diphasique capillaire (10) selon l'une des revendications 1 à 3, **caractérisé en ce que** les barres qui constituent la maille (1) ont un profil en étoile.

5. Diffuseur thermique diphasique capillaire (10) selon l'une des revendications 1 à 4, **caractérisé en ce que** le diffuseur thermique capillaire (10) est une chambre à vapeur (15), le treillis (9) est compris entre deux plaques planes de la chambre à vapeur sur lesquelles ledit treillis (9) est rigidement fixé.

6. Diffuseur thermique diphasique capillaire (10) selon l'une des revendications 1 à 4, **caractérisé en ce que** le diffuseur thermique (10) est un caloduc de la forme d'un cylindre de révolution.

7. Diffuseur thermique diphasique capillaire (10) selon l'une des revendications 1 à 6, **caractérisé en ce que** le treillis (9) comprend un nombre entier supérieur ou égal à deux de demi-mailles (1).

8. Diffuseur thermique diphasique capillaire (10) selon l'une des revendications 1 à 7, **caractérisé en ce que** le diffuseur thermique capillaire (10) est un ensemble monobloc comprenant l'enveloppe (11) et le treillis (9) parcourant tout ou partie du volume interne (20), ledit treillis (9) prenant naissance sur des portions opposées de l'enveloppe (11).

9. Procédé de fabrication d'un diffuseur thermique capillaire (10) selon la revendication 8 **caractérisé en ce qu'**il comprend une étape de constructions du treillis tridimensionnel par fabrication additive par lequel l'enveloppe et le treillis sont fabriqués ensemble.

10. Procédé de fabrication d'un diffuseur thermique capillaire (10) selon la revendication 9 **caractérisé en ce que** la fabrication additive est faite par addition d'aluminium ou d'alliage d'aluminium.
